# FASCICULE DE BREVET EUROPEEN

(11) **EP 2 048 510 B1**
(45) Date de publication et mention de la délivrance du brevet: **28.09.2011**
(21) Numéro de dépôt: 08290929.2
(22) Date de dépôt: 02.10.2008
(51) Int. Cl.: G01R 33/02, F41H 11/16

(54) **Dispositif de test du fonctionnement d'un générateur de champ magnétique**
Vorrichtung zum Testen der Funktionsfähigkeit eines Magnetfeldgenerators
Device for testing the operation of a magnetic field generator

(30) Priorité: 08.10.2007 FR 0707024
(43) Date de publication de la demande: 15.04.2009
(73) Titulaire: NEXTER Systems, 42328 Roanne Cedex (FR)
(72) Inventeur: Huet, Guillaume, 18023 Bourges Cedex (FR); Pezard, Michel, 18023 Bourges Cedex (FR)
(74) Mandataire: Célanie, Christian

(56) Documents cités:
- US-A- 5 256 960
- US-A- 5 440 232
- US-A1- 2002 101 226
- US-B1- 6 204 661
- US-B1- 6 486 664
- US-B1- 6 809 520

## Description

Le domaine technique de l'invention est celui des dispositifs permettant de tester le fonctionnement d'un générateur de champ magnétique.

L'invention est plus particulièrement adaptée au test des bobines utilisées dans les systèmes de déminage.

On connaît par le brevet FR-2779529 un dispositif de test qui permet d'évaluer le niveau d'intensité d'un champ magnétique variable.

Ce dispositif comprend un capteur de champ magnétique couplé à un circuit électronique de traitement du signal. Le circuit assure une comparaison entre le signal détecté et une valeur de consigne. Il fournit le résultat de la comparaison à l'aide d'un afficheur.

Ce dispositif est bien adapté pour la réalisation de cartographies du champ magnétique à distance du générateur et pour assurer une mesure du niveau du champ (à l'aide d'un moyen permettant de faire varier la valeur de consigne).

Il est par contre d'emploi trop complexe pour permettre la simple validation ou vérification du bon fonctionnement d'un générateur. Par ailleurs la sensibilité du capteur est maximale suivant une direction bien définie qui doit être repérée par rapport au générateur pour éviter une erreur d'évaluation.

US 5 440 232 décrit un dispositif dosimètre portatif permettant de mesurer et stocker les données relatives à l'exposition d'un individu aux champs électromagnétiques.

US 2002/101226 A1 décrit un dispositif de mesure de l'efficacité d'un écran de protection anti-rayonnement pour ordinateur individuel.

US 5 256 960 décrit un testeur du niveau de champ magnétique.

US 6 204 661 B1 décrit un détecteur de champ magnétique destiné à être couplé à un moyen de traitement thérapeutique mettant en oeuvre des aimants pivotants.

US 6 809 520 B1 décrit un dispositif permettant de détecter les munitions enterrées.

US 6 486 664 B1 décrit un capteur de champ magnétique permettant de contrôler un procédé de chauffage par induction.

Il existe donc un besoin d'un dispositif de test rustique et bon marché permettant de valider d'une façon fiable le bon fonctionnement d'un générateur de champ magnétique.

L'invention a pour but de fournir un tel dispositif.

Ainsi l'invention a pour objet un dispositif de test du fonctionnement d'un générateur de champ magnétique, et notamment d'une bobine de déminage, dispositif comprenant au moins un moyen d'évaluation du niveau du champ magnétique couplé à au moins un moyen d'affichage, le moyen d'évaluation comprenant au moins un bobinage pouvant être positionné de façon à être traversé par les lignes du champ magnétique, bobinage relié à une électronique d'évaluation qui est alimentée en courant par le bobinage lui-même, dispositif caractérisé en ce que l'électronique d'évaluation comprend au moins deux voies d'évaluation distinctes permettant chacune de tester une fréquence de champ magnétique différente, les deux voies d'évaluation étant couplées simultanément au même moyen d'affichage et au travers d'une porte logique OU.

Selon un mode de réalisation, chaque voie d'évaluation associe un étage de filtrage et un étage d'évaluation.

Selon un autre mode de réalisation, l'électronique d'évaluation associe une voie d'évaluation configurée pour une fréquence de l'ordre de la dizaine de Hz et une voie d'évaluation configurée pour une fréquence supérieure au kilo Hz.

Selon un autre mode de réalisation, chaque étage d'évaluation comprend un oscillateur qui est calibré à une fréquence distincte pour la voie haute fréquence et pour la voie basse fréquence, chaque oscillateur assurant ainsi le fonctionnement du moyen d'affichage avec une fréquence distincte.

Selon un autre mode de réalisation, l'électronique d'évaluation comprend un module de stockage d'énergie comportant au moins une capacité.

Selon un autre mode de réalisation, le moyen d'affichage comprend au moins un voyant lumineux.

Selon un autre mode de réalisation, le moyen d'affichage comprend un voyant lumineux unique disposé au niveau d'une face supérieure du dispositif.

Selon un autre mode de réalisation, le bobinage est solidaire d'un boîtier délimitant un alésage destiné à coiffer un générateur à tester.

L'invention sera mieux comprise à la lecture de la description qui va suivre d'un mode particulier de réalisation, description faite en référence aux dessins annexés et dans lesquels :
- la figure 1 est un schéma montrant la mise en place d'un dispositif selon l'invention sur une bobine de déminage,
- la figure 2 est une vue en coupe d'un dispositif selon un mode de réalisation de l'invention,
- la figure 3 est un schéma d'un mode de réalisation du moyen d'évaluation du dispositif selon l'invention,
- la figure 4 est un schéma d'un deuxième mode de réalisation du moyen d'évaluation du dispositif selon l'invention,
- la figure 5 est un schéma montrant la mise en place d'un dispositif selon ce dernier mode de réalisation de l'invention pour tester une bobine de déminage fonctionnant à haute fréquence.

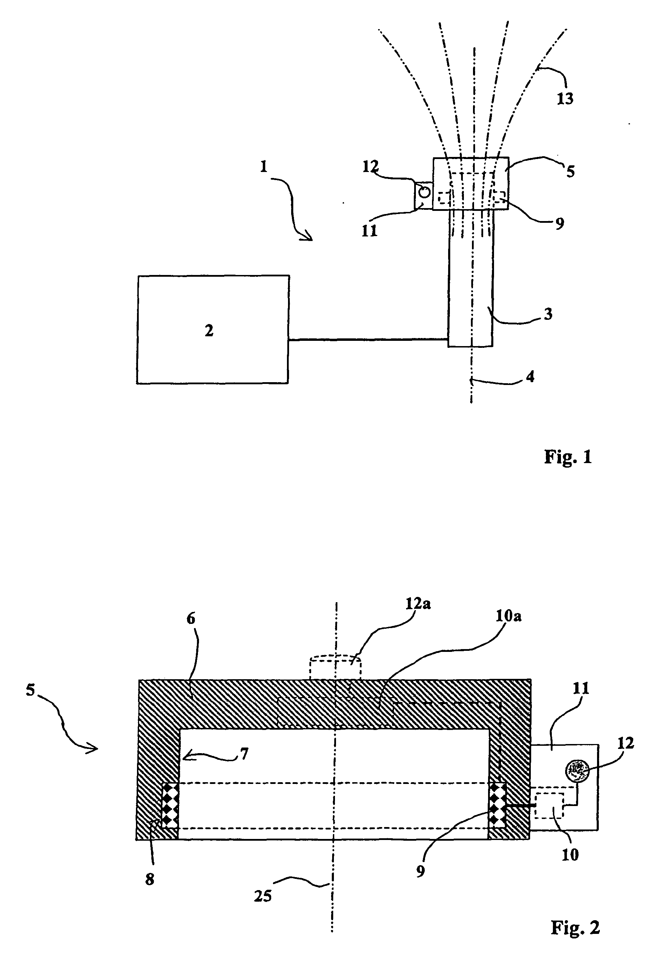

La figure 1 montre schématiquement un dispositif de déminage 1 comprenant une source de courant 2 reliée à un générateur de champ magnétique 3 constitué par une bobine cylindrique d'axe 4 qui est solidaire d'un véhicule (non représenté).

Un tel dispositif de déminage est décrit par le brevet FR2750204, il n'est donc pas nécessaire de le décrire plus en détails.

La bobine 3 est représentée ici coiffée par un dispositif de test 5 selon l'invention.

La figure 2 montre en coupe un mode de réalisation de ce dispositif de test 5.

Ce dernier comprend un boîtier 6 délimitant un alésage cylindrique 7 d'axe 25 destiné à coiffer la bobine 3 et qui a donc un diamètre sensiblement égal au diamètre externe de la bobine 3. Le boîtier 6 comporte une encoche cylindrique 8 dans laquelle est positionné un enroulement d'un conducteur formant un bobinage 9. Le bobinage 9 pourra être rendu solidaire du boîtier 6 par surmoulage ou par collage.

Le bobinage 9 est relié à une électronique de mesure 10 disposée dans un coffret 11 solidaire du boîtier 6. L'électronique de mesure 10 est reliée à un moyen d'affichage 12 constitué par un voyant. Le bobinage 9 et l'électronique de mesure 10 constituent un moyen d'évaluation du niveau du champ magnétique.

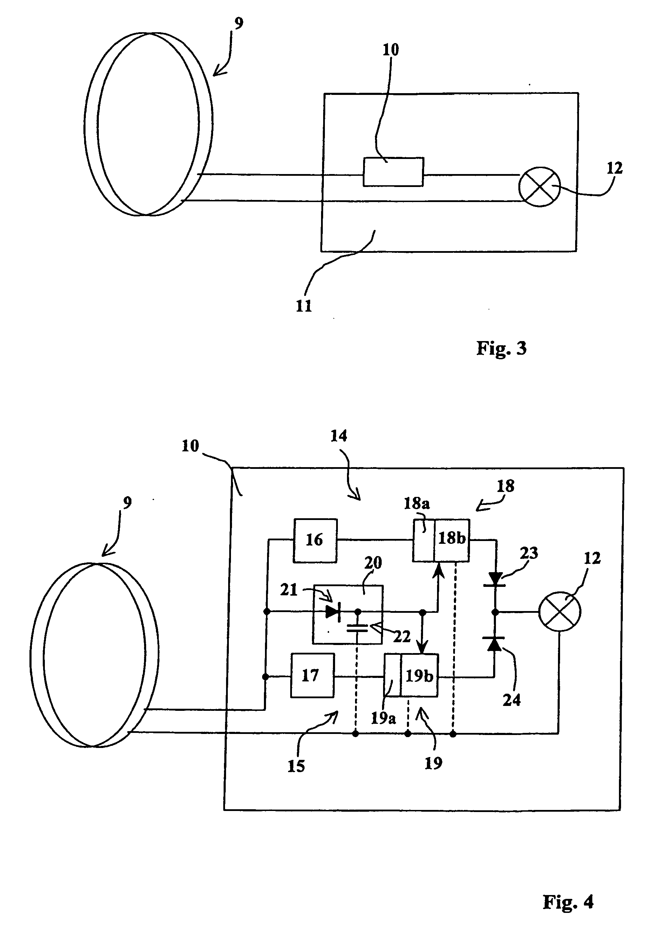

La figure 3 montre un exemple de réalisation de ce moyen d'évaluation. Le bobinage 9 est relié au voyant 12 par l'intermédiaire d'un circuit comportant au moins une résistance calibrée 10.

Le circuit ainsi constitué ne comprend pas de source d'énergie. Il est alimenté en courant par le bobinage 9 lorsque ce dernier est traversé par les lignes de champ 13 (figure 1) engendrées par le générateur 3 et que ce champ varie en fonction du temps.

La valeur de la résistance calibrée 10 est choisie en fonction du niveau du champ magnétique que l'on cherche à tester.

Pour un bobinage donné, la force électromotrice du bobinage est proportionnelle à l'intensité du champ magnétique et elle est par ailleurs proportionnelle à la fréquence de variation de ce champ.

L'Homme du Métier choisira la valeur de la résistance de telle sorte que le voyant 12 ne s'allume que si le champ magnétique a les caractéristiques souhaitées du point de vue de l'intensité et de la fréquence.

Par ailleurs le nombre de spires du bobinage 9 sera choisi de façon à assurer (lorsqu'il est couplé avec un des générateurs 3 à tester) un niveau d'intensité de courant induit suffisant pour permettre l'allumage du voyant 12.

Le dispositif selon l'invention est donc particulièrement simple et rustique. Par ailleurs le voyant ne peut s'allumer que si un champ magnétique variable est présent.

Le dispositif permet donc de mettre en évidence deux types de défaut : la panne dans laquelle le champ est de niveau insuffisant et la panne dans laquelle le champ est continu même si son niveau est suffisant en valeur absolue.

Le bon fonctionnement du générateur est repéré par l'allumage et l'extinction périodique du voyant 12. La fréquence d'allumage correspond à celle du champ magnétique engendré.

Différentes variantes sont possibles sans sortir du cadre de l'invention. Il est possible de prévoir plusieurs voyants 12 orientés de façon différente, cela afin de faciliter le repérage du bon fonctionnement pour un opérateur situé à distance.

A titre d'exemple on a représenté en pointillés sur la figure 2 un voyant 12a qui est disposé au niveau d'une face supérieure du dispositif 5 et qui est raccordé à une électronique de mesure 10a noyée dans le corps du dispositif.

Il est bien entendu possible de mettre en oeuvre l'invention avec une électronique de mesure différente. On pourra par exemple prévoir un circuit comprenant un filtre passe bande et détecteur de niveau crête, circuit conçu de façon à délivrer un signal continu qui est une image de l'amplitude crête à crête de la tension engendrée par induction dans le bobinage 9, donc également de l'amplitude du champ magnétique reçu.

Ce signal pourra être dirigé vers un comparateur qui recevra un signal constant fourni par un moyen de consigne. Le comparateur commandera l'allumage du voyant si le signal reçu est supérieur ou égal à la consigne.

On assurera là encore l'alimentation en énergie électrique de l'électronique de mesure à partir du courant qui est induit par le champ magnétique dans le bobinage.

Ce mode de réalisation permettra d'adapter le dispositif à différents types de générateurs en modifiant la valeur de consigne.

La figure 4 montre un dispositif de test suivant un deuxième mode de réalisation de l'invention.

Suivant ce mode l'électronique d'évaluation 10 comprend deux voies d'évaluations distinctes 14 et 15 qui permettent chacune de tester une fréquence de champ magnétique différente.

Il existe en effet des dispositifs de déminage fonctionnant suivant des fréquences d'emploi différentes, par exemple des dispositifs de déminage à basse fréquence (fréquence de l'ordre de la dizaine de Hertz) et des dispositifs de déminage à haute fréquence (supérieure au kilo Hertz). Ces dispositifs fonctionnant à haute et à basse fréquence peuvent par ailleurs être associés sur un même véhicule.

Chaque voie d'évaluation 14, 15 comprend un étage de filtrage 16, 17 suivi d'un étage d'évaluation 18, 19.

Chaque étage de filtrage 16, 17 est réalisé d'une façon classique par l'association de résistances et de capacités. Il permet de ne laisser passer vers l'évaluateur 18 ou 19 considéré que la partie du signal fournie par le bobinage 9 et qui correspond à la fréquence recherchée par la voie d'évaluation.

Par exemple, l'étage de filtrage basse fréquence 16 sera calibré pour laisser passer les fréquences de l'ordre de la dizaine de Hz et l'étage de filtrage haute fréquence 17 sera défini pour laisser passer les fréquences supérieures au kHz.

Parallèlement aux étages de filtrage 16,17, le bobinage 9 alimente un module de stockage d'énergie 20. Ce module associe par exemple une diode 21 et une capacité 22.

Le courant alternatif fourni par le bobinage 9 permet de charger la capacité 22.

Ce module 20 a pour fonction, d'une part d'alimenter en énergie les évaluateurs 18 et 19, et d'autre part d'assurer la fourniture d'énergie au voyant 12.

Les modules d'évaluation 18 et 19 comprennent un étage de calibration 18a,19a qui permet de ne retenir qu'une fraction de la tension issue du filtre 16,17. On règle ainsi la sensibilité de la détection pour chaque voie d'évaluation. Ces étages de calibration comprendront d'une façon classique un redresseur suivi d'un pont de résistances.

Les étages de calibration 18a,19a sont raccordés à un oscillateur 18b, 19b (réalisé sous la forme de circuits intégrés). Chaque oscillateur sera calibré à une fréquence bien définie qui sera choisie différente pour la voie haute fréquence 15 et pour la voie basse fréquence 14.

On appliquera ainsi les signaux de calibration fournis par les étages 18a,19a au niveau de l'entrée "remise à zéro" (RAZ) de chaque oscillateur. Ceci aura pour effet de commander l'émission ou non d'un signal par l'oscillateur considéré.

Si un courant de la fréquence recherché est détecté par un des étages 14 ou 15, l'étage de calibration considéré (18a ou 19a) applique une tension à l'entrée RAZ de l'oscillateur 18b ou 19b. Ce dernier est alors débloqué et il fournit un courant périodique au voyant 12 ce qui provoque un allumage périodique de ce voyant avec la fréquence qui a été associée par réglage à l'oscillateur 18b,19b considéré. Si les étages 14 ou 15 ne détectent pas de courant, les oscillateurs sont bloqués et le voyant 12 reste éteint. Des diodes 23,24 sont disposées entre chaque oscillateur et le voyant 12. La combinaison de ces deux diodes constitue une porte logique OU. Le voyant 12 est donc allumé indifféremment par l'une ou l'autre des voies d'évaluation 14,15.

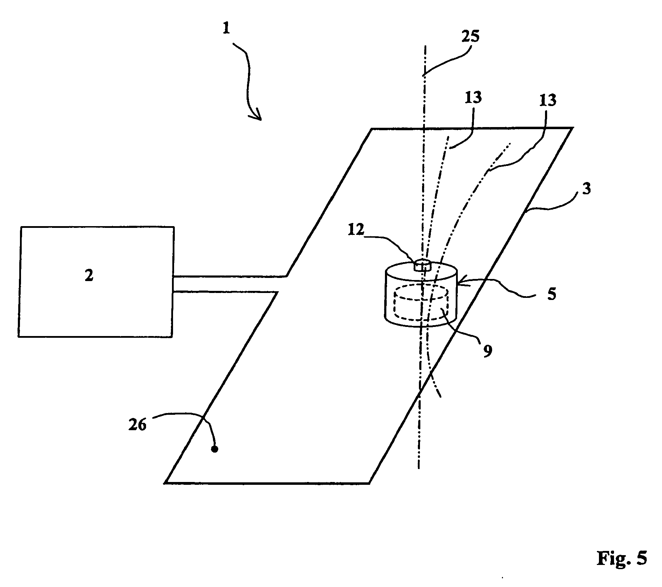

La figure 5 montre le dispositif de test 5 mis en oeuvre pour contrôler un dispositif de déminage 1 fonctionnant en haute fréquence. Ce dispositif de déminage comprend lui aussi une source de courant 2 qui est reliée à un générateur de champ magnétique 3 constitué par une ou plusieurs spires conductrices, qui sont par exemple solidaires d'un organe mécanique solidaire d'un véhicule, par exemple d'une charrue de déminage. Pour contrôler ce générateur de champ magnétique on positionne le dispositif de test 5 selon l'invention à proximité de la ou des spires 3. L'axe 25 du dispositif de test 5 sera disposé sensiblement perpendiculairement au plan 26 de la spire (le plus souvent l'axe 25 est donc sensiblement vertical). Dans une telle position, les lignes 13 du champ magnétique engendré par le générateur 3 traversent le bobinage 9 du dispositif 5 qui peut donc fonctionner.

Le dispositif 5 représenté à la figure 5 comporte un voyant 12 unique disposé au niveau d'un face supérieure du dispositif 5. Ce voyant est donc visible suivant toutes les directions de l'espace. Un dispositif optique approprié pourra être prévu pour assurer la diffusion du rayonnement suivant 360°. On voit ainsi que le dispositif selon ce mode de réalisation de l'invention permet de tester tout aussi facilement un démineur basse fréquence tel que représenté à la figure 1 qu'un démineur haute fréquence tel que représenté à la figure 5.

Le dispositif ne comporte aucune source d'énergie embarquée, aucun bouton de commande ni aucun moyen de réglage. Il est extrêmement rustique et permet de vérifier la présence d'un champ magnétique alternatif d'une intensité donnée (pas d'allumage du voyant si le champ est absent ou continu, s'il est de niveau insuffisant, ou s'il n'est pas dans la bonne bande de fréquence). Il permet aussi de tester des générateurs fonctionnant suivant des fréquences différentes sans intervention ni réglage particulier sur le dispositif.

Par ailleurs les fréquences d'allumage du voyant, qui sont différentes pour les générateurs haute ou basse fréquence, peuvent être aisément détectées par un utilisateur, même inexpérimenté.

## Revendications

1. Dispositif (5) de test du fonctionnement d'un générateur (3) de champ magnétique, et notamment d'une bobine de déminage, le dispositif comprenant au moins un moyen d'évaluation du niveau du champ magnétique couplé à au moins un moyen d'affichage (12), le moyen d'évaluation comprenant au moins un bobinage (9) pouvant être positionné de façon à être traversé par les lignes (13) du champ magnétique, le bobinage (9) étant relié à une électronique d'évaluation (10) qui est alimentée en courant par le bobinage (9) lui-même, le dispositif ***caractérisé en* ce *que*** l'électronique d'évaluation (10) comprend au moins deux voies d'évaluation (14, 15) distinctes permettant chacune de tester une fréquence de champ magnétique différente, les deux voies d'évaluation (14, 15) étant couplées simultanément au même moyen d'affichage (12) et au travers d'une porte logique OU.

2. Dispositif de test selon la revendication 1, **caractérisé en ce que** chaque voie d'évaluation (14, 15) associe un étage de filtrage (16, 17) et un étage d'évaluation (18, 19).

3. Dispositif de test selon une des revendications 1 ou 2, **caractérisé en ce que** l'électronique d'évaluation (10) associe une voie d'évaluation (14, 15) configurée pour une fréquence de l'ordre de la dizaine de Hz et une voie d'évaluation configurée pour une fréquence supérieure au kilo Hz.

4. Dispositif de test selon une des revendications 2 ou 3, **caractérisé en ce que** chaque étage d'évaluation (18, 19) comprend un oscillateur (18b, 19b) qui est calibré à une fréquence distincte pour la voie haute fréquence et pour la voie basse fréquence, chaque oscillateur assurant ainsi le fonctionnement du moyen d'affichage (12) avec une fréquence distincte.

5. Dispositif de test selon une des revendications 1 à 4, **caractérisé en ce que** l'électronique d'évaluation (10) comprend un module de stockage d'énergie (20) comportant au moins une capacité (22).

6. Dispositif de test selon une des revendications 1 à 5, **caractérisé en ce que** le moyen d'affichage (12) comprend au moins un voyant lumineux.

7. Dispositif de test selon la revendication 6, **caractérisé en ce que** le moyen d'affichage comprend un voyant lumineux unique (12) disposé au niveau d'une face supérieure du dispositif (5).

8. Dispositif de test selon une des revendications 1 à 7, **caractérisé en ce que** le bobinage (9) est solidaire d'un boîtier (6) délimitant un alésage (7) destiné à coiffer un générateur à tester.

## Claims

1. A device (5) to test the good working order of a magnetic field generator (3), and namely a demining coil, such device comprising at least one evaluation means for the level of the magnetic field coupled with at least one display means (12), the evaluation means comprising at least one wound coil (9) able to be positioned so that the lines of the magnetic field pass through it, said wound coil (9) being linked to evaluation electronics (10) powered by the wound coil (9) itself, device **characterised in that** the evaluation electronics (10) comprise at least two separate channels (14, 15) each enabling a different frequency of the magnetic field to be tested, the two evaluation channels (14, 15) being coupled at same time with the same display means (12) and through a logic gate OU.

2. A test device according to Claim 1, **characterised in that** each evaluation channel (14, 15) associates a filtering stage (16, 17) and an evaluation stage (18, 19).

3. A test device according to one of Claims 1 or 2, **characterised in that** the evaluation electronics (10) associate an evaluation channel (14, 15) configured for a frequency of around ten Hz or so and an evaluation channel configured for a frequency of over one kilo Hz.

4. A test device according to one of Claims 2 to 3, **characterised in that** each evaluation stage (18, 19) comprises an oscillator (18b, 19b) which is calibrated at a well defined frequency which will be different for the high frequency channel and for the low frequency channel, each oscillator assuming thus the working of the display means (12) with a different frequency.

5. A test device according to one of Claims 1 to 4, **characterised in that** the evaluation electronics (10) comprise an energy storage module (20) incorporating at least one capacitor (22).

6. A test device according to one of Claims 1 to 5, **characterised in that** the display means (12) comprise at least one pilot lamp.

7. A test device according to Claim 6, **characterised in that** the display means comprise a single pilot lamp (12) arranged on an upper face of the device (5).

8. A test device according to one of Claims 1 to 7, **characterised in that** the wound coil (9) is integral with a casing (6) delimiting a bore (7) intended to cap a generator to be tested.

## Patentansprüche

1. Vorrichtung (5) zum Testen der Funktion eines Magnetfeldgenerators (3) und insbesondere einer Spule zum Minenräumen, wobei die Vorrichtung wenigstens ein Mittel zur Auswertung der Höhe des Magnetfeldes umfasst, das an wenigstens ein Anzeigemittel (12) gekoppelt ist, wobei das Auswertungsmittel wenigstens eine Spule (9) umfasst, die derart positioniert sein kann, dass sie von den Magnetfeldlinien (13) durchdrungen wird, wobei die Spule (9) mit einer Auswerteelektronik (10) verbunden ist, welche durch die Spule (9) selbst mit Strom versorgt wird, wobei die Vorrichtung ***dadurch gekennzeichnet ist, dass*** die Auswerteelektronik (10) wenigstens zwei unterschiedliche Wege der Auswertung (14, 15) umfasst, die es jeder einzelnen ermöglichen, eine unterschiedliche Magnetfeldfrequenz zu testen, wobei die beiden Auswertungswege (14, 15) gleichzeitig mit demselben Anzeigemittel (12) und über ein logisches ODER-Gatter gekoppelt sind.

2. Vorrichtung zum Testen nach Anspruch 1, **dadurch gekennzeichnet, dass** jeder Auswertungsweg (14, 15) eine Filterstufe (16, 17) und eine Auswertungsstufe (18, 19) verknüpft.

3. Vorrichtung zum Testen nach einem der Ansprüche 1 oder 2, **dadurch gekennzeichnet, dass** die Auswerteelektronik (10) einen Auswertungsweg (14, 15), der für eine Frequenz in der Größenordnung von Zehn Hz konfiguriert ist, und einen Auswertungsweg, der für eine Frequenz größer als ein KHz konfiguriert ist, verknüpft.

4. Vorrichtung zum Testen nach einem der Ansprüche 2 oder 3, **dadurch gekennzeichnet, dass** jede Auswertungsstufe (18, 19) einen Oszillator (18b, 19b) umfasst, der auf einer unterschiedlichen Frequenz für den Weg hoher Frequenz und für den Weg niedriger Frequenz kalibriert ist, wobei jeder Oszillator so die Funktion des Anzeigemittels (12) mit einer unterschiedlichen Frequenz gewährleistet.

5. Vorrichtung zum Testen nach einem der Ansprüche 1 bis 4, **dadurch gekennzeichnet, dass** die Auswerteelektronik (10) ein Energiespeichermodul (20) mit wenigstens einem Kondensator (22) umfasst.

6. Vorrichtung zum Testen nach einem der Ansprüche 1 bis 5, **dadurch gekennzeichnet, dass** das Anzeigemittel (12) wenigstens eine Kontrolllampe umfasst.

7. Vorrichtung zum Testen nach Anspruch 6, **dadurch gekennzeichnet, dass** das Anzeigemittel eine einzige Kontrolllampe (12) umfasst, die im Bereich einer oberen Fläche der Vorrichtung (5) angeordnet ist.

8. Vorrichtung zum Testen nach einem der Ansprüche 1 bis 7, **dadurch gekennzeichnet, dass** die Spule(9) mit einem Gehäuse (6) fest verbunden ist, das eine Bohrung (7) abgrenzt, die dafür vorgesehen ist, einen zu testenden Generator zu überdecken.
